# EUROPEAN PATENT SPECIFICATION

(11) **EP 0 312 682 B1**
(45) Date of publication and mention of the grant of the patent: **17.08.1994**
(21) Application number: 88105341.7
(22) Date of filing: 02.04.1988
(51) Int. Cl.: H05K 1/00, H05K 9/00, H05K 1/02

(54) **Printed circuit board**
Leiterplatte
Plaque à circuit imprimé

(30) Priority: 19.09.1987 JP 235766/87
(43) Date of publication of application: 26.04.1989
(73) Proprietor: Nippon CMK Corp., Iruma-Gun Saitama (JP)
(72) Inventor: Kawakami, Shin, Higashimatsuyama-shi Saitama (JP); Haruyama, Satoshi, Fujioka-shi Gunma (JP); Okonogi, Hirotaka, Isezaki-shi Gunma (JP); Nikaido, Katsutomo, Isezaki-shi Gunma (JP); Mukai, Norito, Ohta-Ku, Tokyo (JP)
(74) Representative: Schickedanz, Willi, Dipl.-Ing.

(56) References cited:
- US-A- 3 461 524
- US-A- 3 613 230
- US-A- 4 658 334
- US-A- 4 673 904

## Description

The present invention relates to a printed circuit board comprising a base plate having opposed major surfaces, electrically conductive elements formed on at least one major surface of said base plate and shield means covering the conductive elements.

### Description of the Prior Art

From US-A-4 673 904 a support board for interconnecting various electronic components is known. One or more conductors are embedded within the substrate for interconnecting the components. Each conductor is provided with a shielding to permit exchange of high frequency signals between the components without cross-coupled interference.

### Disadvantages of the Prior Art

Although with the above-identified prior art conductors can be shielded against cross-coupled interference it is not possible to shield them against external electric noise.

### Technical Problem

Is is an object of the present invention to provide printed circuit boards having no cross talk and noise effect between conductors and from outside.

### Solution of the Technical Problem

The technical problem is solved by means of the elements of claim 1.

### Brief Description of the Drawings

Figure 1 is a sectional view of a portion of the printed circuit board according to a first embodiment of the present invention.

Figure 2 is a sectional view of a portion of the printed circuit board according to a second embodiment of the invention.

### Detailed Description of the preferred Embodiments

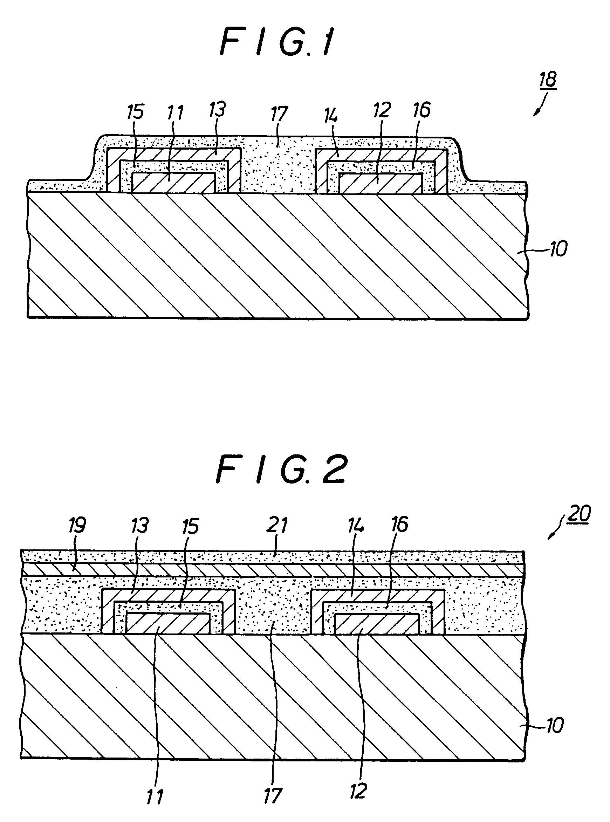

Embodiments of the present invention will now be described in connection with Figs. 1 and 2.

Fig. 1 is a sectional view showing a first embodiment of the present invention. In Fig. 1, numeral 10 designates a base plate on which circuit conductors 11 and 12 are formed.

All the surfaces of the circuit conductors 11 and 12 are covered by insulating layers 15 and 16, and then the insulating layers are covered by shield films 13 and 14. As shown, the ends of the shield films 13 and 14 reach to the surface of the base plate 10 so that all exposed surfaces of the circuit conductors 11 and 12 are electrically covered by the shield films 13 and 14.

Then, insulating layer 17 covers the shield films 13 and 14 to complete a printed circuit board according to the present invention.

In the above described printed circuit board 18, as the all exposed surfaces of all circuit conductors 11 and 12 are covered individually by the shield films 13 and 14, cross talk and noise between the conductors are shielded, and also outer noise effect is shielded by the shield function of the shield films 13 and 14.

To produce the shield films 13 and 14, known paste having shield function is printed on the circuit conductors by e.g. silk screen printing process, and the paste is hardened to form the shield films.

Fig. 2 shows a second embodiment of the printed circuit board according to the present invention. The printed circuit board 20 shown in Fig. 2 is formed by adding shield film 19 on the insulating layer 17 of the printed circuit board 10 shown in Fig. 1. The shield film 19 can be produced by printing paste having shield function by e.g. silk screen printing process and drying the paste.

On the shield film 19, insulating layer 21 is formed. Other construction of the printed cicuit board 20 is similar with the printed circuit board 18 shown in Fig. 1, and same reference numeral is used to show same or similar part or portion, and detailed description will not be repeated.

The above described printed circuit board 20 attains all functional effect of the printed circuit board 18 shown in Fig. 1, and also, outer noise effect to the circuit conductors 11 and 12 can be completely shielded by the added shield film 19.

As described in detail, the printed circuit board according to the present invention shields cross talk and noise between circuit conductors, and also shields outer noise effectively from reaching the circuit conductors.

## Claims

1. A printed circuit board, comprising:
1.1 a base plate (10) having opposed major surfaces;
1.2 electrically conductive elements (11, 12) formed on at least one major surface of said base plate (10);
1.3 shield means (13, 14) covering the conductive elements (11, 12);
**characterized by**
1.4 an insulating layer (15, 16) formed directly on and covering all electrically exposed surfaces of each respective electrically conductive elements (11, 12);
1.5 a shield film (13, 14) formed over all exposed surfaces of each respective insulating layer (15, 16) to effectively shield the electrically conductive elements (11, 12) from external electric noise; and
1.6 another insulating layer (17) formed on and covering all exposed surfaces of the shield films (13, 14) and the exposed surface of said one major surface of said base plate (10).

2. A printed circuit board according to claim 1, **characterized in that** electrically conductive elements (11) are mounted on the other surface of said base plate (10); an insulating layer (15, 16) formed directly on and covering all electrically exposed surfaces of each respective electrically conductive elements (11, 12) formed on the other major surface is provided; and a sheet film (13, 14) formed over all exposed surfaces of each respective aforesaid insulating layer (15, 16) is provided.

3. A printed circuit board according to claim 1, **characterized in that** another shield film (19) is formed over said another insulating layer (17) and extending over the first-mentioned shield films (13, 14).

4. A printed circuit board according to claim 3, **characterized in that** another insulating layer (21) is formed directly on and covering the exposed surface of said another shield film (19).

5. A printed circuit board according to claim 1, **characterized in that** the electrically conductive elements (11, 12) are formed directly on the one major surface of said base plate (10).

6. A printed circuit board according to claim 1, **characterized in that** said shield films (13, 14) are composed of a hardened paste material.

## Patentansprüche

1. Gedruckte Leiterplatte, mit:
1.1 einer Grundplatte (10) mit zwei sich gegenüberliegenden Hauptflächen;
1.2 elektrisch leitenden Elementen (11, 12), die auf mindestens einer Hauptfläche der Grundplatte (10) angebracht sind;
1.3 einer Abschirmung (13, 14), welche die leitenden Elemente (11, 12) bedeckt;
**gekennzeichnet durch**
1.4 eine isolierende Schicht (15, 16), welche direkt auf allen elektrisch exponierten Flächen jedes der jeweiligen elektrisch leitenden Elemente (11, 12) aufgebracht ist und diese bedeckt;
1.5 eine abschirmende Schicht (13, 14), die über allen exponierten Flächen jeder jeweiligen isolierenden Schicht (15, 16) aufgebracht ist, um die elektrisch leitenden Elemente (11,12) wirksam von äußerem elektrischen Rauschen abzuschirmen; und
1.6 eine weitere isolierende Schicht (17), welche auf allen exponierten Flächen der abschirmenden Flächen (13, 14) und der exponierten Fläche der einen Hauptfläche der Grundplatte (10) aufgebracht ist und diese bedeckt.

2. Gedruckte Leiterplatte nach Anspruch 1, **dadurch gekennzeichnet**, daß elektrisch leitende Elemente (11) auf der anderen Fläche der Grundplatte (10) aufgebracht sind; eine isolierende Schicht (15, 16) vorgesehen ist, die direkt auf allen auf der anderen Hauptfläche aufgebrachten, elektrisch exponierten Flächen jedes der jeweiligen elektrisch leitenden Elemente (11, 12) aufgebracht ist und diese bedeckt; und daß eine Folie (13, 14) vorgesehen ist, die über allen exponierten Flächen jeder jeweiligen vorgenannten isolierenden Schicht (15, 16) aufgebracht ist.

3. Gedruckte Leiterplatte nach Anspruch 1, **dadurch gekennzeichnet**, daß eine weitere abschirmende Schicht (19) über der weiteren isolierenden Schicht (17) aufgebracht ist und sich über die zuerst erwähnten abschirmenden Schichten (13, 14) erstreckt.

4. Gedruckte Leiterplatte nach Anspruch 3, **dadurch gekennzeichnet**, daß eine weitere isolierende Schicht (21) direkt auf der exponierten Fläche der weiteren abschirmenden Schicht (19) aufgebracht ist und diese bedeckt.

5. Gedruckte Leiterplatte nach Anspruch 1, **dadurch gekennzeichnet**, daß die elektrisch leitenden Elemente (11, 12) direkt auf der einen Hauptfläche der Grundplatte (10) aufgebracht sind.

6. Gedruckte Leiterplatte nach Anspruch 1, **dadurch gekennzeichnet**, daß die abschirmenden Schichten (13, 14) aus einem gehärteten Pastenmaterial bestehen.

## Revendications

1. Plaque à circuit imprimé comprenant
1.1. une plaque de base (10) ayant des surfaces principales opposées;
1.2. des éléments électriquement conducteurs (11, 12), formés sur au moins une surface principale de ladite plaque de base (10);
1.3. des écrans (13, 14) recouvrant les éléments conducteurs (11, 12);
caractérisée par
1.4. une couche isolante (15, 16) formée directement sur et recouvrant toutes les surfaces électriquement dégagées de chacun des éléments électriquement conducteurs correspondants (11, 12);
1.5. un film d'écran (13, 14) formé sur toutes les surfaces dégagées de chaque couche isolante correspondante (15, 16) pour protéger efficacement les éléments électriquement conducteurs (11, 12) du bruit électrique extérieur; et
1.6. une autre couche isolante (17) formée sur et recouvrant toutes les surfaces dégagées des films de protection (13, 14) et la surface dégagée de ladite surface principale de ladite plaque de base (10).

2. Plaque à circuit imprimé selon la revendication 1, caractérisée en ce que les éléments électriquement conducteurs (11) sont montés sur l'autre surface de ladite plaque de base (10); qu'une couche isolante (15, 16) est formée directement sur et recouvre toutes les surfaces électriquement dégagées de chacun des éléments électriquement conducteurs correspondants (11, 12) formés sur l'autre surface principale et il existe un film de feuille (13, 14) formé sur toutes les surfaces dégagées de chaque couche isolante correspondante précitée (15, 16).

3. Plaque à circuit imprimé selon la revendication 1, caractérisée en ce qu'un autre film de protection (19) est formé sur l'autre couche isolante (17) et s'étend par dessus les films de protection précités (13, 14).

4. Plaque à circuit imprimé selon la revendication 3, caractérisée en ce qu'une autre couche isolante (21) est formée directement sur et recouvre la surface dégagée dudit autre film de protection (19).

5. Plaque à circuit imprimé selon la revendication 1, caractérisée en ce que les éléments électriquement conducteurs (11, 12) sont formés directement sur une surface principale de ladite plaque de base (10).

6. Plaque à circuit imprimé selon la revendication 1, caractérisée en ce que lesdits films de protection (13, 14) sont composés d'un matériau en pâte durcie.
